# EUROPÄISCHE PATENTSCHRIFT

(11) **EP 0 325 575 B1**
(45) Veröffentlichungstag und Bekanntmachung des Hinweises auf die Patenterteilung: **07.09.1994**
(21) Anmeldenummer: 89890016.2
(22) Anmeldetag: 23.01.1989
(51) Int. Cl.: G03B 41/00, G03F 7/20

(54) **Anordnung zur Stabilisierung einer bestrahlten Maske**
Device for stabilizing an illuminated mask
Dispositif de stabilisation d'un masque illuminé

(30) Priorität: 22.01.1988 AT 118/88
(43) Veröffentlichungstag der Anmeldung: 26.07.1989
(73) Patentinhaber: IMS Ionen Mikrofabrikations Systeme Gesellschaft m.b.H., A-1020 Wien (AT); Österreichische Investitionskredit Aktiengesellschaft, 1013 Wien (AT)
(72) Erfinder: Glavish, Hilton F., Dr., Salem, Mass.01970 (US); Löschner, Hans, Dr., A-1190 Wien (AT); Stengl, Gerhard, Dr., A-9241 Wernberg Kärnten (AT); Chalupka, Alfred, Dr., A-1170 Wien (AT)
(74) Vertreter: Matschnig, Franz, Dipl.-Ing.

(56) Entgegenhaltungen:
- EP-A- 222 737
- EP-A- 250 391
- DE-A- 2 702 444
- US-A- 4 619 030
- JOURNAL OF VACUUM SCIENCE & TECHNOLOGY: PART B vol. 5, no. 1, January/February 1987, New York, US, pp. 278-282 ; M. KARNEZOS et al.: "X-ray mask heating during electron-beam patterning"
- PATENT ABSTRACTS OF JAPAN vol. 7, no. 222 (E-201)(1367) 04 October 1983 ; & JP-A-58 112 329

## Beschreibung

Die Erfindung bezieht sich auf eine Anordnung zur Stabilisierung einer bestrahlten Maske für eine elektromagnetische oder Teilchenstrahlung verwendende Lithographieeinrichtung, die für die Strahlung durchlässige Strukturen aufweist.

Durch die US-PS 4 619 030 wurde eine Temperaturregelung bei der Behandlung von Si-Wafern in einer evakuierten Kammer bekannt. Die Temperatur des Si-Wafers wird dabei durch Änderung der zum und vom Si-Wafer führenden Wärmeströme gesteuert. Der Si-Wafer ist dabei in der Nähe einer Wärmesenke mit geschwärzter Oberfläche angeordnet. Zwischen dem Wafer und der Wärmesenke ist ein bzw. sind mehrere reflektierende Elemente angeordnet. Das bzw. die Elemente sind bewegbar, um einen größeren oder kleineren Abschnitt der Oberfläche der Wärmesenke abzudecken.

Zur Zeit stellen die Methoden zur Herstellung von weitgehend stressfreien Maskenfolien, die im Betrieb einer höheren Wärmebeanspruchung ausgesetzt sind und dabei plan und innerhalb von tolerablen Grenzen verzerrungsfrei bleiben müssen, ein aktuelles Problem in Mikrofabrikationssystemen dar.

In der EP-223770 bzw. der EP-222737 sind Verfahren beschrieben, bei welchen die Stabilisierung der Maskenfolie durch thermische Vorspannung bzw. Rahmenheizung der Maskenfolie erzielt wird.

Bei Belastung einer thermisch vorgespannten Maske durch das Abbildungsmedium, also einem Elektronen- oder Ionenstrahl od.dgl., bleibt die Lage der Strukturen in der Maske innerhalb eines durch den Temperaturhub definierten Belastungsbereiches praktisch unverändert, da durch die Strahlungsbelastung lediglich die thermische Vorspannung verringert wird. Die Lage und die Form der Strukturen der vorgespannten Maske ist jedoch gegenüber der nicht gespannten Maske verändert. Nachteilig ist bei diesem Verfahren, daß zwar die Maske beim Betrieb plan bleibt, jedoch die Dimensionen der Maske und die Lage der Maskenstrukturen durch das Vorspannen geändert werden. Aus diesem Grunde ist dieses Verfahren nur an Testmasken anwendbar. Weiters genügt bei thermisch vorgespannten Masken die Vorspannung nicht, wenn die Maske einer so hohen Strahlungsbelastung ausgesetzt wird, daß die thermische Vorspannung, die nur innerhalb des elastischen Bereiches zulässig ist, vollkommen aufgebraucht wird.

Bei der Rahmenheizung wird der die Maske haltende Rahmen auf eine Temperatur aufgeheizt, die gleich oder etwas höher ist als die Temperatur der Maske, wodurch letztere während des Betriebes auch eben und weitgehend stressfrei bleibt, so daß intolerable Verzerrungen vermieden werden. Ein Nachteil ist darin zu erblicken, daß bei einer Rahmenheizung ein Maskenwechsel mit Problemen verbunden ist und zwar insbesondere dann, wenn die Maske öfters und rasch gewechselt werden muß, wie dies bei Produktionsmaschinen der Fall ist Dazu muß der Maskenrahmen nicht nur rasch aufgeheizt, sondern auch zum Entfernen der Maske rasch gekühlt werden können. Außerdem verändern sich bei dieser Ausbildung bei Temperaturänderungen die Dimensionen der Maske.

Der Erfindung liegt die Aufgabe zugrunde, eine Anordnung der eingangs genannten Art zu schaffen, mittels welcher eine weitgehend streß- und verzerrungsfreie Maske so verwendet werden kann, daß sich die Maske auch während des Betriebes in einem zulässigen Spannungsbereich befindet, um unter den Strahlungsbelastungen eine strukturtreue Abbildung des durchlässigen Bereiches der Maske auf das Substrat sicherzustellen. Außerdem ist dabei zu gewährleisten, daß die Maske auch während der Belastung durch die Strahlung innerhalb der vorgegebenen Toleranzgrenze auf derselben Temperatur bleibt.

Erfindungsgemäß werden die genannten Aufgaben dadurch gelöst, daß zwischen der Maske und der Strahlenquelle und/oder nach der Maske, den Strahlengang umschließend, eine oder mehrere vorzugsweise aus elektrisch leitendem Material, insbes. Metall gefertigte, eine geringere Temperatur als die Maske aufweisende Kühlflächen, vorzugsweise in gleichem Abstand von der Achse des Strahlenganges, angebracht sind, wobei die Abstände der Kühlflächen von der Achse des Strahlenganges größer sind als der Abstand des Randes des Bereiches der Maske, der die Strukturen enthält, von der Achse des Strahlenganges, daß die Maske in einer, insbes. durch Beheizung der Wände, auf konstante Temperatur, insbes. Raumtemperatur, eingeregelten Kammer angeordnet ist und in der Kammer an eine Stelle nach einer im Strahlengang liegenden, gegebenenfalls verschließbaren, Öffnung einer Kammerwand bewegbar ist und daß die Kühlflächen im Abstrahlfeld der Maske liegen, wenn diese im Strahlengang an der Stelle nach der Öffnung angeordnet ist, wodurch die Temperatureinwirkung der Strahlung auf die Maske durch die Kühlflächen kompensierbar ist und die Maske auch bei Bestrahlung annähernd die Kammertemperatur beibehält. Dadurch wird die Maskentemperatur soweit konstant gehalten, daß die Maske auch unter der Strahlungsbelastung noch eben und weitgehend verzerrungsfrei bleibt.

In einer leverzugten Ausführung ist die Öffnung durch eine einen Teil der Kammerwand bildende Abblendeinrichtung verschließbar.

Bei der erfindungsgemäßen Anordnung ist es dabei möglich, daß man bei einer vorgegebenen Strahlungsleistung des Abbildungsmediums entweder die Maske, z.B. bestehend aus Maskenrahmen und Maskenfolie, auf Zimmertemperatur beläßt und dafür die Kühlflächen auf tiefere Temperaturen (gegebenenfalls unter Anwendung eines Kühlmittels) bringt, oder umgekehrt, die Maske auf einer über der Zimmertemperatur gelegenen Temperatur hält und die Kühlflächen, was technisch auch einfacher sein kann, auf Zimmertemperatur beläßt. Im zweiten Fall kann nämlich das die Maske umgebende Lithographiesystem selbst die Kühlflächen auf Zimmertemperatur bilden. Eine weitere Möglichkeit ist noch dadurch gegeben, daß man die Maske auf einer über der Zimmertemperatur gelegenen Temperatur hält und die Kühlflächen auf einer Temperatur hält, die unter der Zimmertemperatur liegt.

Ein wesentlicher Unterschied zu dem Verfahren der Rahmenheizung (und Kühlung des Rahmens zwecks Entfernens der Maske) ist dadurch gegeben, daß durch die erfindungsgemäße Anordnung die genannten Aufgaben technisch wesentlich einfacher gelöst werden können, da hierbei die gesamte Maske durch die Wärmestrahlung einer die Maske umgebenden Kammer auf Zimmertemperatur oder, wie vorher erwähnt, gegebenenfalls auch auf eine höhere Temperatur gebracht werden kann und daher nicht allein der Maskenrahmen geheizt (bzw. gekühlt) werden muß. Die Kammertemperatur gibt dabei über die Wärmestrahlung die Maskentemperatur vor. Es muß daher auf den Maskenrahmen kein Temperaturzyklus ausgeübt werden, um die Formstabilität der Maske sicherzustellen, wodurch die Masken einfach und rasch gewechselt werden können.

Die Temperatur der Maskenfolie wird durch die Leistungsdichte einerseits der auftreffenden Strahlen (des Abbildungsmediums) und anderseits der abgeführten Wärme bestimmt. Da die Maskenfolien so dünn sind, daß praktisch keine Wärmeleitung statfindet, erfolgt die Wärmeabfuhr praktisch nur durch Strahlung. Die Strahlungskühlung, also die Bilanz zwischen an die Umgebung abgegebener und von der Umgebung aufgenommener Leistungsdichte, ist proportional zu (T_{M}⁴ - T_{K}⁴), wobei T_{M} die Temperatur der Maskenfolie ist und T_{K} die Temperatur der Umgebung, jeweils in Kelvin. Damit die Umgebungstemperatur möglichst weitgehend von der eingestellten Temperatur der Kühlflächen bestimmt wird, muß der Raumwinkel Ω, unter dem die von der Maske ausgehenden Wärmestrahlen auf die Kühlflächen auftreffen können, möglichst groß sein. Ferner hängt die Strahlungskühlung vom "relativen Strahlungsemissionsvermögen" ε der Folienoberfläche ab, d.i. das Verhältnis zwischen der Abstrahlung der gegenständlichen Oberfläche zur Abstrahlung eines schwarzen Körpers derselben Temperatur.

Um eine möglichst gleichmäßige Strahlungskühlung zu erzielen, kann die Kühlfläche durch ein, vorzugsweise konzentrisch zur Achse des Strahlenganges angeordnetes, an sich bekanntes Kühlrohr gebildet sein.

Zur Steigerung der Kühlwirkung können an der der Strahlenquelle abgewandten Seite der Maske eine oder mehrere Kühlflächen angeordnet sein, insbesondere in Gestalt eines konzentrisch zur Achse angeordneten Kühlrohres.

Das Material und die Oberfläche des Kühlrohres sollen dabei solche physikalischen Eigenschaften aufweisen, daß die auf das Kühlrohr auftreffenden Wärmestrahlen möglichst völlig absorbiert werden. Die Kühlelemente sollen so vorgearbeitet sein, daß von außen, abgesehen von der Wirkung der Strahlungsquelle (des Abbildungsmediums), keine Wärmestrahlung auf die Maske gelangen kann. Außerdem ist es wichtig, daß das Material des Kühlrohres gute thermische Leitfähigkeit aufweist, um die aufgenommene Wärme abführen zu können. Weiters muß bei Elektronen- und Ionenlithographiesystemen das Material des Kühlrohres elektrisch leitend sein, damit sich keine elektrischen Ladungen auf der Oberfläche bilden können, die ihrerseits zeitlich nicht konstante Störfelder erzeugen können.

Vorteilhafterweise kann die Innenwandung des (der) Kühlrohre(s) mit umlaufenden Rillen versehen sein, welche vorzugsweise durch ein Gewinde, insbesondere mit geneigten Flanken, gebildet ist, wobei die Innenwandung gegebenenfalls mit absorptionsförderndem Material, vorzugsweise Graphit, beschichtet ist. Dadurch werden bessere Absorptionseigenschaften des Kühlrohres erzielt, da der Anteil der reflektierten Wärmestrahlen einerseits stark verringert wird, anderseits der reflektierte Anteil größenteils wieder auf das Kühlrohr auftrifft und dort absorbiert werden kann.

Um den Raumwinkel, in dem die Umgebungstemperatur von der Temperatur der gekühlten Fläche bestimmt wird, zu vergrößern, können an die Kühlflächen bzw. das (die) Kühlrohr(e) an den von der Maske weiter entfernten Enden anschließend, eine oder mehrere bis nahe zur Strahlenquelle reichende Deckflächen vorgesehen sein.

Zur Steigerung des Emissionsvermögens ε der Maske können die den Kühlflächen zugewandten Oberflächen der Maske mit einem emissionsfördernden Material, vorzugsweise Kohlenstoff, beschichtet sein, womit eine möglichst maximale Strahlungskühlung der Maske erreicht wird.

In der Kammer, in der die Maske bewegbar angeordnet ist, können zusätzlich zur Maske weitere Elemente der Lithographieeinrichtung, z.B. Maskenwechsler und Verschlußklappen (Shutter) zum teilweisen oder gänzlichen Ausblenden der Strahlung, angeordnet werden. Die Maske bzw. die Masken werden dabei durch ihre Anordnung in der Kammer über die Wärmestrahlung die Temperatur der Kammerwandung annehmen.

Eine Maske kann innerhalb dieser Kammer mit Hilfe eines Maskenwechslers bewegt werden, ohne Temperatur- und Strukturverhältnisse der Maske zu ändern. Ein Teil der Kammer kann sich innerhalb des Strahlenganges der Lithographieeinrichtung befinden, wobei in dem von der Strahlung getroffenen Teil der Kammer ein oder mehrere Shutter angeordnet sind. Die Shutter sind in geschlossenem Zustand als Teile der Kammerwandung aufzufassen. Bei geschlossenem Shutter wird die der Strahlungsquelle zugewandte Shutteroberfläche gleichzeitig auch dem Kühlrohr ausgesetzt und damit wird bei geeignetem Shuttermaterial bzw. bei geeigneter Beschichtung des Shutters die Shuttertemperatur nicht geändert. Bei geschlossener Shutterstellung kann also eine Maske rasch und einfach, etwa über einen in Drehung versetzbaren Maskenwechsler in die Belichtungsstation der Kammer, also in dem von der Strahlung durchsetzten Teil der Kammer, bewegt und dort fixiert werden. Wenn nun der Shutter zwischen Strahlungsquelle und Maske in die geöffnete Stellung gebracht wird, wird die Maske in dem vom Shutter oder einer darüberliegenden Apertur vorgegebenen Bereich bestrahlt. Gleichzeitig ist dieser bestrahlte Bereich den Kühlelelementen ausgesetzt. Entsprechend dem Emissionsvermögen ε des Maskenmaterials, der einfallenden Strahlungsleistung und der Temperatur der Kühlelelemente kann durch die erfindungsgemäße Anordnung ein Gleichgewicht zwischen Strahlungs- und Kühlwirkung hergestellt werden, sodaß die Temperatur der bestrahlten Maske sich nur um einen tolerablen Betrag gegenüber der Temperatur der unbestrahlten Maske ändert. Somit kann die Maske dauernd der Strahlung und Kühlung ausgesetzt werden. Durch Schließen des Shutters wird wiederum keine Änderung der Maskentemperatur bewirkt, da der Shutter nun als Teil der Kammerwand wirkt. Sodann kann die Maske leicht von der Belichtungsstation wegbewegt werden und gegebenenfalls kann eine andere Maske in die Belichtungsposition gebracht werden. Neue Masken können leicht aus bzw. in die Kammer geschleust werden, da die gesamte Maske, bestehend aus einer Maskenfolie und einem die Maskenfolie tragenden Maskenrahmen, gewechselt werden kann, ohne daß - wie bei der Maskenrahmenheizung - komplizierte mechanische Vorgänge notwendig sind.

Da die Shutter und dgl. auf der Achse des Lithographiesystems an einem anderen Ort als die Maske angeordnet sind, ist bei gleichem Emissionsvermögen der Shutter- und Maskenoberfläche, durch Änderung des Raumwinkels, unter dem die Kühlflächen wirken können, die für den Shutter erzielbare Kompensation von Strahlung und Kühlung nicht zusammen mit der Maske optimierbar. Dies bedeutet jedoch keinen Nachteil, da einerseits beim Shutter auch durch Wärmeleitung ein Temperaturausgleich stattfindet, anderseits für die Shutter wesentlich größere Temperaturtoleranzen als für die Maske erlaubt sind. Dabei kann der Maskenwechsler als Maskenträger ein Maskenrad aufweisen, dessen Drehache außerhalb des Strahlenganges liegt. Es kann jedoch auch der Maskenwechsler einen linear verschiebbaren Maskenträger aufweisen. Der Shutter, der verhindert, daß die Maske zu einem unerwünschten Zeitpunkt bestrahlt und/oder gekühlt wird, kann zwischen dem Kühlrohr und dem Maskenwechsler bzw. dem der Strahlungsquelle näheren Gehäuseteil der Kammer und dem Maskenwechsler angeordnet sein, wobei der Shutter bei Ausfall der Strahlung bzw. der Kühlung automatisch schließt. Dieser Shutter kann als verschiebbares oder auch als rotierendes Element ausgebildet sein, wobei bei einem rotierenden Shutter die Drehachse des Shutters außerhalb des Strahlenganges angeordnet ist. Mit Hilfe dieses Shutters wird vermieden, daß im Falle des Ausfalls der Strahlungsbelastung, die Maskentemperatur durch das Kühlrohr soweit herabgesetzt wird, daß plastische Verformungen der Maske, nunmehr durch zu starke Abkühlung, auftreten. Die Maske wird also, wenn sie der Bestrahlung ausgesetzt ist, immer auch gleichzeitig dem Kühlrohr ausgesetzt. Dabei kann bei Anordnung von Kühlflächen nach der Maske eine Abblendeinrichtung zwischen der Maske und den nach der Maske angeordneten Kühlflächen vorgesehen sein.

Ein wesentlicher Vorteil der erfindungsgemäßen Kühlanordnung liegt auch darin, daß sowohl die Kammer als auch - bedingt durch die von der Kammerwand kommende Wärmestrahlung - die in der Kammer befindlichen einzelnen Elemente auf einer vorgegebenen Temperatur, bevorzugt auf Zimmertemperatur bzw. auf einer etwas höheren Temperatur gehalten werden können, sodaß ein Maskenwechsel innerhalb der Kammer problemlos und rasch vonstatten gehen kann. Dieser Vorteil ist bei allen Lithographieeinrichtungen von wesentlicher Bedeutung, insbesondere jedoch, wenn die Maskenfolie öfters und rasch gewechselt werden muß, wie dies bei Produktionsmaschinen der Fall ist. Außerdem ist ein Zugang zu anderen Teilen der Kammer leicht möglich. Dadurch könne Masken vom Maskenrad leicht entnommen bzw. dort angebracht werden.

Ein weiterer wesentlicher Vorteil der erfindungsgemäßen Anordnung liegt auch noch darin, daß man die Maske nur minimal vorzuspannen braucht, so daß sie gerade eben ist, also nicht durchhängt, da ja die Maske keiner strahlungsbedingten Temperaturbelastung ausgesetzt ist, die das Spannungsniveau herabsetzen würde.

Aus der theoretischen Arbeit von J.N.Randall et al, Mat.Res.-Soc.Symp.proc.vol.76,pp 73-77 (1987) ist beispielsweise zu entnehmen, daß eine initiale Spannung von 2 x 10⁷ N/m² in einer 2 µm dicken Si-Maskenfolie mit einer Fläche von 50 x 50 mm zu fabrikationsinduzierten Verzerrungen geringer als 0,5 µm führt, wenn in die Maske Strukturen geätzt werden. Eine derartige Siliziummaske kann mit diesen tolerablen Verzerrungen in der erfindungsgemäßen Anordnung verwendet werden.

Die Erfindung wird nachstehend anhand der Zeichnung beispielsweise erläutert.

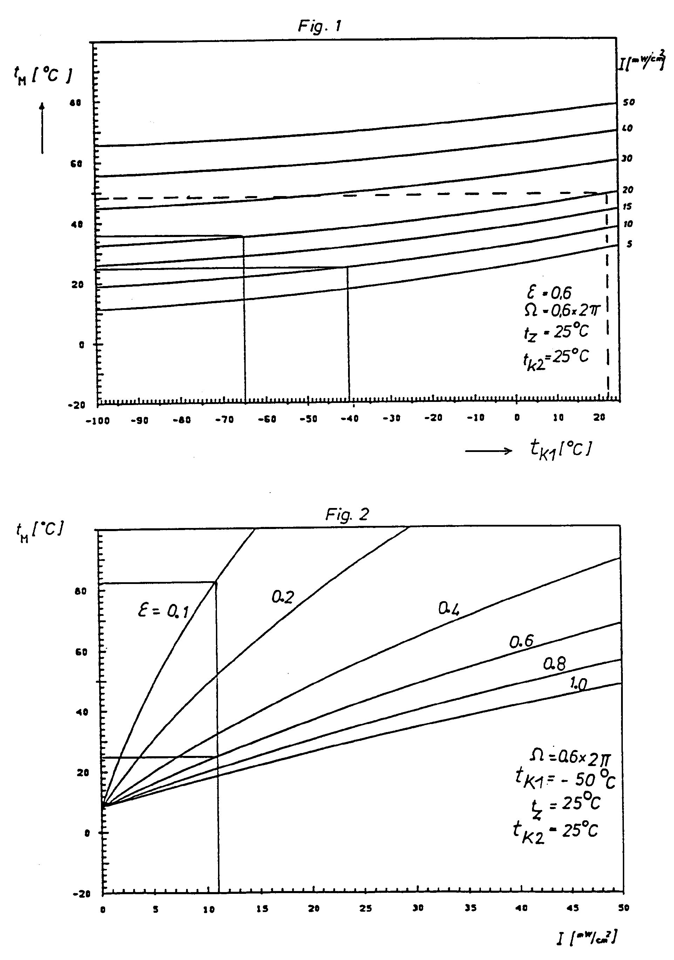

Die Fig. 1 und 2 zeigen beispielsweise die berechnete Abhängigkeit der Maskentemperatur t_{M} von der Temperatur tₖ₁ eines Kühlrohres und von der einfallenden Strahlleistung I, wobei für die Temperatur der Kammer (tₖ₂) ein Wert von 25°C angenommen wurde. Aus Fig. 1 ist zu entnehmen (ausgezogene Linie), daß die Maske bei einem Emissionsvermögen ε = 0,6 und bei einem mittleren Raumwinkel Ω = 0,6 x 2 π und einer einfallenden Strahlungsleistung I von 10 mW/cm² mit einem Kühlrohr K1 der Temperatur von tₖ₁ ca. -40°C gekühlt werden muß, damit die Maskentemperatur t_{M} gleich der Temperatur in der Kammer, nämlich t_{M} = 25°C verbleibt.

Bei höheren Strahlleistungen, z.B. I = 20 mW/cm², muß, wie aus Fig. 1 ersichtlich, die Maske über eine Kammerheizung von vorneherein auf eine etwas höhere Temperatur (etwa t_{M} = tₖ₂ = 35°C) gebracht werden, damit es noch möglich ist, mit technisch einfach zu realisierenden Kühlrohrtemperaturen tₖ₁ ≧ -100°C, die Maskentemperatur auch während der Bestrahlung auf den Wert tₖ₂ zu halten.

Ohne Kühlrohr, sondern beispielsweise bei einer Umgebungstemperatur von 25°C (also mit t_{K1} = t_{K2} = 25°C) würde die Maske bei der Belastung mit 20mW/cm² auf eine Temperatur von etwa 50°C erwärmt werden (strichlierte Linien), wodurch temperaturinduzierte Verzerrungen hervorgerufen werden können und bei Verwendung von Masken mit geringer Vorspannung ein Entspannen und Durchhängen der Maskenstrukturen verursacht werden kann.

Fig. 2 zeigt die Maskentemperatur tM in Abhängigkeit von der Strahlleistung I für t_{K1} = -50°C, t_{K2} = 25°C, ε = 0,6 und Ω = 0,6 x 2 π. Die Ergebnisse zeigen, daß für eine Belastung mit 11 mW/cm² und bei einer Strahlungskühlung mit t_{K1} = -50°C die Maskentemperatur für eine Oberfläche mit ε = 0,6 auf Kammertemperatur t_{K2} = 25°C bleibt, während sich die Maskentemperatur z.B. bis auf etwa 80°C erhöht, wenn ein anderes Oberflächenmaterial mit einem Emissionsvermögen von ε = 0,1 verwendet wird. Ein Emissionsvermögen von ε = 0,6 gilt für Siliziumoberflächen, während ε = 0,1 typisch für Metalloberflächen erreicht wird. Metallmasken sind daher vorteilhaft mit einem Material wie beispielsweise Graphit (ε ≧ 0,9) zu beschichten.

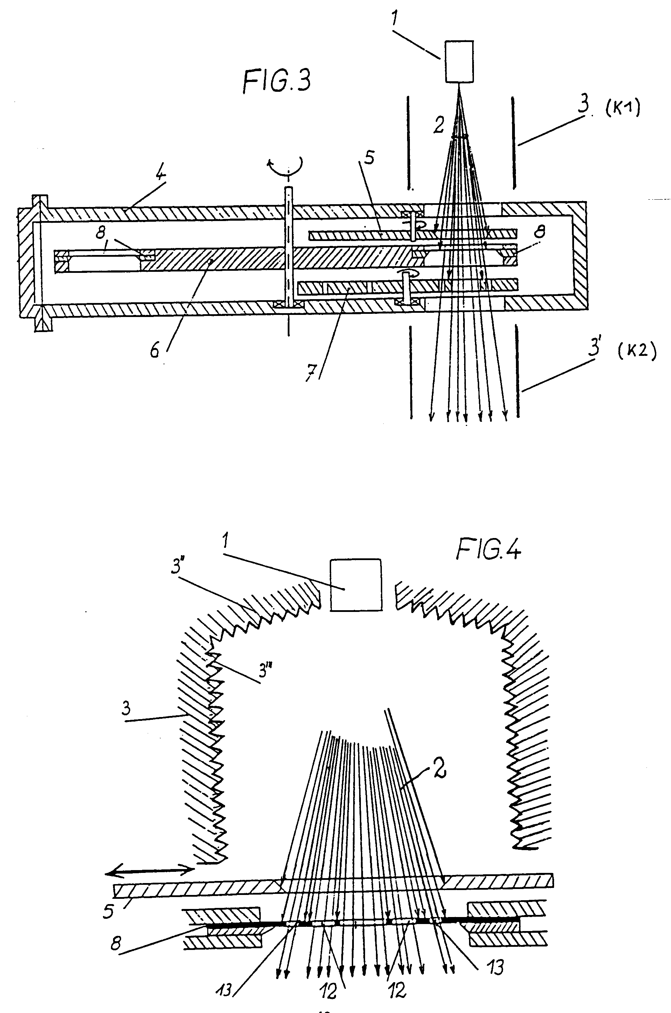

Fig. 3 zeigt schematisch die Anordnung eines Kühlrohres und einer von einer Ionenquelle bestrahlten Maske sowie einen Shutter.

Fig. 4 zeigt in schematischer Darstellung den oberen Teil einer erfindungsgemäß ausgebildeten Ionenprojektionslithographieeinrichtung ohne das nachfolgende ionenoptische Linsensystem.

Mit 1 ist eine Strahlungsquelle einer Ionenprojektonslithographieeinrichtung bezeichnet, in deren Strahlengang 2 sich eine Kammer 4 befindet, in welcher ein Maskenwechsler 6 sowie ein rotierender Shutter 7 und ein bei Ausfall des Strahls automatisch schließender Shutter 5 angeordnet sind. Die Shutter können auch translatorisch bewegbar ausgebildet sein.

Zwischen der Kammer 4 und der Strahlungsquelle 1 ist ein Kühlrohr 3 (K1) angeordnet, das den Strahlengang umschließend, koaxial mit der optischen Achse der Einrichtung angeordnet ist, wobei der Durchmesser des Kühlrohres größer als der Durchmesser der Maskenfolie ist. Das Kühlrohr liegt somit nicht im Strahlengang der Strahlungsquelle 1. Bei 3′ ist ein weiteres Kühlrohr (K2) angedeutet.

Um den Einfluß der Umgebungstemperatur auf den Raum innerhalb des Kühlrohres möglichst klein zu halten, wird an das Kühlrohr bevorzugt noch ein weiteres, Deckflächen 3˝ bildendes Kühlelement so angebracht, daß es zu dem Kühlrohr unter einer bestimmten Neigung steht und nahe bis zur Strahlungsquelle verlängert ist, um den Abstand zwischen der Strahlungsquelle und dem Kühlrohr möglichst gering zu halten. Die Innenwandung des Kühlrohres 3 ist mit Rillungen versehen, welche bei dem dargestellten Ausführungsbeispiel als Gewinde 3˝′ ausgebildet ist, wobei die einzelnen Gänge des Gewindes dreieckigen Querschnitt aufweisen. Die Neigung der schrägen Flanken des Gewindes ist dabei so ausgelegt, daß die Bedingungen für mehrfache Reflexionen erfüllt sind, so daß sowohl die von der Maske 8 emittierten Wärmestrahlen als auch die von der Umgebung einfallenden Wärmestrahlen höchstens so reflektiert werden, daß sie nicht auf die Maske 8 zurückgelangen, sondern wegen der oben beschriebenen Ausführung der Innenwand wieder auf das Kühlrohr auftreffen und schließlich völlig absorbiert werden können.

## Patentansprüche

1. Anordnung zur Stabilisierung einer bestrahlten Maske für eine elektromagnetische oder Teilchenstrahlen verwendende Lithographieeinrichtung, die für die Strahlung durchlässige Strukturen aufweist, dadurch gekennzeichnet, daß zwischen der Maske (8) und der Strahlenquelle (1) und/oder nach der Maske (8), den Strahlengang (2) umschließend, eine oder mehrere, vorzugsweise aus elektrisch leitendem Material, insbesondere Metall gefertigte, eine geringere Temperatur als die Maske aufweisende Kühlflächen (3), vorzugsweise in gleichem Abstand von der Achse des Strahlenganges (2), angebracht sind, wobei die Abstände der Kühlflächen (3) von der Achse des Strahlenganges (2) größer sind als der Abstand des Randes des Bereiches der Maske, der die Strukturen enthält, von der Achse des Strahlenganges (2), daß die Maske (8) in einer, insbes. durch Beheizung der Wände, auf konstante Temperatur, insbes. Raumtemperatur, eingeregelten Kammer (4) angeordnet ist und in der Kammer (4) an eine Stelle nach einer im Strahlengang liegenden, gegebenenfalls verschließbaren, Öffnung einer Kammerwand bewegbar ist und daß die Kühlflächen (3) im Abstrahlfeld der Maske (8) liegen, wenn diese im Strahlengang an der Stelle nach der Öffnung angeordnet ist, wodurch die Temperatureinwirkung der Strahlung auf die Maske durch die Kühlflächen kompensierbar ist und Maske auch bei Bestrahlung annähernd die Kammertemperatur beibehält.

2. Anordnung nach Anspruch 1, einschließlich der verschließbaren Öffnung, dadurch gekennzeichnet, daß die Öffnung durch eine einen Teil der Kammerwand bildende Abblendeinrichtung (5) verschließbar ist.

3. Anordnung nach Anspruch 2, dadurch gekennzeichnet, daß in der Kammer (4) ein Maskenwechsler (6) und eine weitere Abblendeinrichtung (7) zum teilweisen oder gänzlichen Ausblenden der Strahlung, angeordnet sind.

4. Anordnung nach Anspruch 3, dadurch gekennzeichnet, daß die Abblendeinrichtungen (5, 7) bei Ausfall der Strahlung bzw. der Kühlung automatisch Schließen.

5. Anordnung nach Anspruch 4, dadurch gekennzeichnet, daß die Abblendeinrichtungen (5, 7) in an sich bekannter Weise als rotierende oder verschiebbare Elemente ausgebildet sind, wobei bei einem rotierenden Element als Abblendeinrichtung die Drehachse außerhalb des Strahlenganges (2) angeordnet ist.

6. Anordnung nach einem der Ansprüche 3 bis 5, dadurch gekennzeichnet, daß bei Anordnung einer oder mehrerer Kühlflächen (3′) nach der Maske (8) die weitere Abblendeinrichtung (7) zwischen der Maske (8) und der nach der Maske (8) angeordneten einen oder mehreren Kühlflächen (3′) vorgesehen ist.

7. Anordnung nach einem der Ansprüche 1 bis 6, dadurch gekennzeichnet, daß die Kühlfläche (3) als an sich bekanntes, vorzugsweise konzentrisch zur Achse des Strahlenganges (2) angeordnetes Kühlrohr ausgebildet ist.

8. Anordnung nach Anspruch 1 bis 7, dadurch gekennzeichnet, daß die Kühlfläche bzw. die Kühlflächen mit Rillen an ihrer dem Strahlengang zugewandten Fläche versehend sind, welche vorzugsweise durch ein Gewinde (14), insbesondere mit geneigten Flanken, gebildet werden.

9. Anordnung nach einem der Ansprüche 1 bis 8, dadurch gekennzeichnet, daß die Innenwandung der Kühlflächen (3) mit absorptionsförderndem Material, vorzugsweise Graphit, beschichtet ist.

10. Anordnung nach einem der Ansprüche 1 bis 9, dadurch gekennzeichnet, daß an die Kühlfläche bzw. Kühlflächen (3) an den von der Maske weiter entfernten Enden anschließend eine oder mehrere bis nahe zur Strahlenquelle (1) reichende Deckflächen (3˝) vorgesehen sind.

11. Anordnung nach einem der Ansprüche 1 bis 10 einschließlich der Maske (8), dadurch gekennzeichnet, daß die den Kühlflächen (3) zugewandte Oberfläche der Maske (8) mit einem die Wärmeabstrahlung fördernden Material, vorzugsweise Graphit, beschichtet ist.

12. Lithographieeinrichtung mit einer Anordnung zur Stabilisierung einer bestrahlten Maske, nach einem der Ansprüche 1 bis 11, wobei die Kühlflächen zur Strahlungskühlung der Maske von der die Maske umgebenden Lithographieeinrichtung gebildet werden.

## Claims

1. An arrangement for stabilising a radiation-exposed mask for an electromagnetic lithographic device or a lithographic device using corpuscular rays, which arrangement comprises structures allowing the radiation to pass though, characterised in that between the mask (8) and the radiation source (1) and/or after the mask (8), surrounding the radiation emission (2), one or a plurality of cooling surfaces (3), preferably produced from electrically conductive material, especially metal, and of a lower temperature than the mask are attached preferably at the same distance from the axis of the radiation emission (2), wherein the distances of the cooling surfaces (3) from the axis of the radiation emission (2) are greater than the distance of the edge of the region of the mask, which region contains the structures, from the axis of the radiation emission (2), that the mask (8) is disposed in a chamber (4) regulated at constant temperature, in particular room temperature, in particular by the heating of the walls and is moveable in the chamber (4) to a position after an opening in the chamber wall, which opening can be closed if necessary and lies in the radiation emission, and that the cooling surfaces (3) lie in the radiation field of the mask (8) when this is disposed in the radiation emission in the position after the opening, wherein the temperature influence of the radiation on the mask can be compensated by the cooling surfaces and keeps the mask close to the chamber temperature even during exposure to radiation.

2. An arrangement according to claim 1 including the closable opening, characterised in that the opening is closable by means of a screen device (5) forming part of the chamber wall.

3. An arrangement according to claim 2, characterised in that in the chamber (4), a mask changeover device (6) and a further screen device (7) are disposed to partially or completely mask out the radiation.

4. An arrangement according to claim 3, characterised in that the screen devices (5, 7) automatically close in the absence of radiation or cooling.

5. An arrangement according to claim 4, characterised in that the screen devices (5, 7) are formed, in a manner known per se, as rotating or displaceable elements, wherein in the case of a rotating element as a screen device, the rotation axis is disposed outside the radiation emission (2).

6. An arrangement according to one of claims 3 to 5, characterised in that in the case of the arrangement of one or a plurality of cooling surfaces (3′) after the mask (8), the further screen device (7) is provided between the mask (8) and the one or more cooling surfaces (3′) disposed after the mask (8).

7. An arrangement according to one of claims 1 to 6, characterised in that the cooling surface (3) is formed as a cooling tube, known per se, disposed preferably concentric to the axis of the radiation emission (2).

8. An arrangement according to claims 1 to 7, characterised in that the cooling surface or surfaces is/are provided with grooves on its/their surface facing the radiation emission, which are preferably formed by a thread (14), in particular with inclined edges.

9. An arrangement according to one of claims 1 to 8, characterised in that the inner wall of the cooling surfaces (3) is coated with absorption promoting material, preferably graphite.

10. An arrangement according to one of claims 1 to 9, characterised in that, attached to the cooling surface or surfaces (3), at the ends further from the mask, one or a plurality of covering surfaces (3˝) extending almost to the radiation source are provided.

11. An arrangement according to one of claims 1 to 10, including the mask (8), characterised in that the surface of the mask (8) facing the cooling surfaces (3) is coated with a material promoting heat dissipation, preferably graphite.

12. A lithographic device having an arrangement for stabilising a radiation-exposed mask, according to one of claims 1 to 11, wherein the cooling surfaces for radiant cooling the mask are formed by the lithographic device surrounding the mask.

## Revendications

1. Agencement pour la stabilisation d'un masque exposé à un rayonnement pour un dispositif de lithographie électro-magnétique ou utilisant des faisceaux de particules, masque qui présente des structures laissant passer le rayonnement, **caractérisé** en ce que sont disposées, entre le masque (8) et la source de rayonnement (1) et/ou à la suite du masque (8), une ou plusieurs surfaces de refroidissement (3) réalisées de préférence en matériau électro-conducteur, notamment en métal, qui présentent une température inférieure à celle du masque, entourent la marche des rayons (2) et sont de préférence équidistantes de l'axe de la marche des rayons (2), la distance entre les surfaces de refroidissement (3) et l'axe de la marche des rayons (2) étant inférieure à la distance entre le bord de la zone du masque contenant les structures et l'axe de la marche des rayons (2), en ce que le masque (8) est disposé dans une chambre (4) maintenue, notamment en chauffant les parois, à température constante, notamment à la température ambiante, et peut être déplacé, dans la chambre (4), à un endroit situé à la suite d'une ouverture éventuellement obturable d'une paroi de la chambre, ouverture qui se trouve dans la marche des rayons, et en ce que les surfaces de refroidissement (3) se trouvent dans le champ de radiation du masque (8) lorsque ce dernier est disposé dans la marches des rayons, à l'endroit situé à la suite de l'ouverture, de sorte que l'action thermique du rayonnement sur le masque peut être compensée par les surfaces de refroidissement et que le masque conserve, même pendant son exposition au rayonnement, approximativement la température de la chambre.

2. Agencement selon la revendication 1, y compris l'ouverture obturable, **caractérisé** en ce que l'ouverture peut être obturée par un dispositif obturateur (5) constituant une partie de ladite paroi de la chambre.

3. Agencement selon la revendication 2, **caractérisé** en ce qu'un dispositif de changement de masque (6) et un dispositif obturateur supplémentaire (7), pour diaphragmer partiellement ou totalement le rayonnement, sont disposés dans la chambre (4).

4. Agencement selon la revendication 3, **caractérisé** en ce que les dispositifs obturateurs (5, 7) se ferment automatiquement en l'absence du rayonnement ou du refroidissement.

5. Agencement selon la revendication 4, **caractérisé** en ce que les dispositifs obturateurs (5, 7) sont réalisés, d'une manière en soi connue, sous la forme d'éléments rotatifs ou coulissants et, en cas d'élément rotatif comme dispositif obturateur, l'axe de rotation est disposé en dehors de la marche des rayons (2).

6. Agencement selon l'une quelconque des revendications 3 à 5, **caractérisé** en ce qu'en cas de disposition d'une ou plusieurs surfaces de refroidissement (3′) à la suite du masque (8), le dispositif obturateur supplémentaire (7) est prévu entre le masque (8) et la ou les surfaces de refroidissement (3′) disposées à la suite du masque (8).

7. Agencement selon l'une quelconque des revendications 1 à 6, **caractérisé** en ce que la surface de refroidissement (3) est réalisée sous la forme d'un tube de refroidissement en soi connu, disposé de préférence concentriquement à l'axe de la marche des rayons (2).

8. Agencement selon l'une quelconque des revendications 1 à 7, **caractérisé** en ce que la ou les surfaces de refroidissement sont pourvues, sur leur face tournée vers la marche des rayons, de rainures qui sont de préférence formées par un filetage (3˝′), notamnent à flancs inclinés.

9. Agencement selon l'une quelconque des revendications 1 à 8, **caractérisé** en ce que la paroi intérieure des surfaces de refroidissement (3) est enduite de matériau favorisant l'absorption, de préférence de graphite.

10. Agencement selon l'une quelconque des revendications 1 à 9, **caractérisé** en ce que sont prévues une ou plusieurs surfaces de recouvrement (3˝), qui se raccordent aux extrémités les plus éloignées du masque de la ou les surfaces de refroidissement (3) et s'étendent jusqu'à proximité de la source de rayonnement (1).

11. Agencement selon l'une quelconque des revendications 1 à 10, y compris le masque (8), **caractérisé** en ce que la surface du masque (8) qui est tournée vers les surfaces de refroidissement (3) est enduite d'un matériau favorisant la dissipation thermique, de préférence de graphite.

12. Dispositif de lithographie avec un agencement pour la stabilisation d'un masque exposé à un rayonnement selon l'une quelconque des revendications 1 à 11, les surfaces de refroidissement pour le refroidissement du masque par radiation étant formées par le dispositif de lithographie entourant le masque.
